(19) Europäisches Patentamt
European Patent Office
Office européen des brevets

(11) **EP 0 641 081 B1**

(12) **FASCICULE DE BREVET EUROPEEN**

(45) Date de publication et mention de la délivrance du brevet:
**03.03.1999 Bulletin 1999/09**

(51) Int Cl.⁶: **H03L 7/093**, H03L 7/107

(21) Numéro de dépôt: **94410069.2**

(22) Date de dépôt: **29.08.1994**

(54) **Boucle à verrouillage de phase comprenant un filtre numérique**

Phasenregelkreis mit einem digitalen Filter

PLL comprising a digital filter

(84) Etats contractants désignés:
**DE FR GB IT**

(30) Priorité: **31.08.1993 FR 9310578**

(43) Date de publication de la demande:
**01.03.1995 Bulletin 1995/09**

(73) Titulaire: **STMicroelectronics S.A.**
**94250 Gentilly (FR)**

(72) Inventeur: **Glass, William**
**F-38170 Seyssinet-Pariset (FR)**

(74) Mandataire: **de Beaumont, Michel**
**1bis, rue Champollion**
**38000 Grenoble (FR)**

(56) Documents cités:
**EP-A- 0 356 548**       **DE-A- 3 532 857**

## Description

La présente invention concerne la réalisation d'un filtre utilisé dans une boucle à verrouillage de phase numérique et sera plus particulièrement exposée en relation avec l'application d'une telle boucle à verrouillage de phase dans un système de récupération de porteuse d'un modem couplé à une ligne téléphonique.

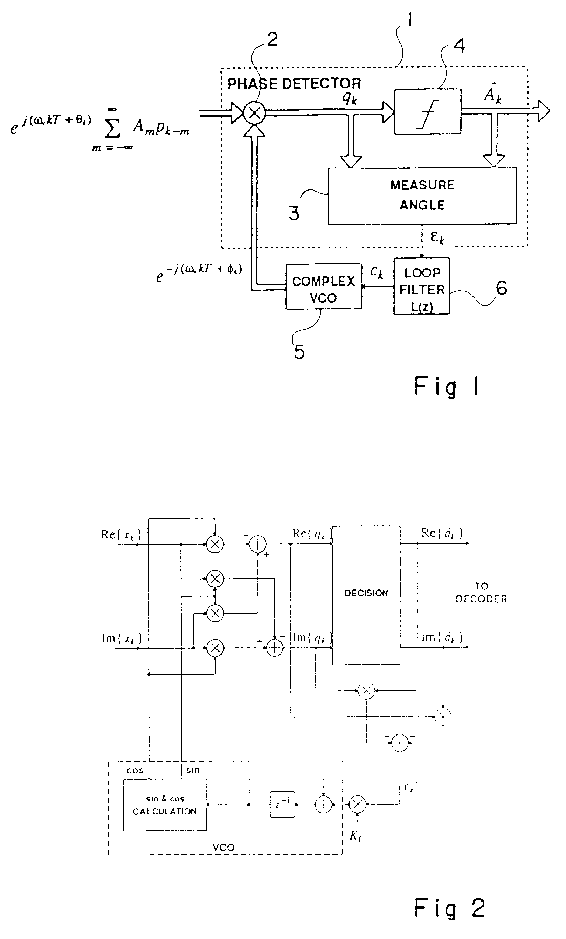

Pour tout ce qui concerne les applications de la présente invention aux modem, on considèrera comme connu l'ouvrage "Digital Communication" de E. A. Lee et D. G. Messerschmitt, Kluwer Academic Publishers, quatrième édition, 1992. On considèrera plus particulièrement comme connu le chapitre 14 de cet ouvrage intitulé "Carrier Recovery" (récupération de porteuse), PP 548-557, dont les figures 14-2 et 14-6 sont reproduites dans les figures 1 et 2 ci-jointes.

On se placera ici dans les mêmes hypothèses que celles énoncées au début de ce chapitre 14. On suppose que l'horloge d'échantillonnage, ou horloge de symboles ou de bauds, a une fréquence connue et que l'on vise seulement à effectuer une récupération précise de la fréquence porteuse en tenant compte d'un décalage de fréquence et d'une gigue de phase.

Pour cela, les circuits d'entrée d'un modem déterminent à partir du signal analogique reçu sur la ligne téléphonique, une fois à chaque période de l'horloge d'échantillonnage, un signal complexe qui, si la transmission était exempte de tout défaut, devrait correspondre à un symbole émis. Comme le représente la figure 1, ce signal complexe est appliqué à l'entrée d'un détecteur de phase 1 et plus particulièrement à une première entrée d'un multiplieur 2. La sortie du multiplieur 2 est envoyée à la première entrée d'un système de mesure d'angle 3 et à l'entrée d'un circuit de décision 4. L'autre entrée du système de mesure d'angle 3 est constituée par la sortie du circuit de décision 4 qui estime, à partir de tables mémorisées, quelles sont la phase et l'amplitude du symbole présentant des caractéristiques les plus voisines du symbole reçu. Le circuit de mesure d'angle détermine la différence ou erreur angulaire $\varepsilon_k$ entre le symbole reçu et le symbole estimé et utilise cette différence pour recaler un oscillateur ou VCO complexe 5 fournissant un signal complexe qui va servir à "démoduler" dans le multiplieur 2 le signal d'entrée. Entre le système 3 de mesure d'angle d'erreur et l'entrée du VCO complexe 5 est prévu un filtre de boucle 6. On reconnaît bien là une boucle à verrouillage de phase numérique classique, la différence étant que le signal de référence au lieu d'être fourni de façon externe est une estimation fournie par le circuit de décision 4.

La figure 14-6 de l'ouvrage susmentionné, reproduite dans la figure 2 ci-après, donne un exemple de réalisation du circuit de la figure 1. On ne décrira pas en détail ce circuit dans lequel des notations mathématiques classiques désignent des parties réelles et des parties imaginaires. On notera seulement dans la partie inférieure droite de la figure qu'il est donné un exemple de filtre utilisable. En l'espèce, le filtre est un filtre du type intégral comprenant un multiplieur multipliant le signal d'erreur par une constante $K_L$. A chaque période d'horloge, la sortie du multiplieur est additionnée au contenu d'un registre $z^{-1}$. On trouve donc bien à la sortie du registre une erreur cumulée qui correspond à une intégration de l'erreur.

Un problème qui se pose avec le filtre utilisé dans cette application particulière et plus généralement dans les filtres de boucle PLL est que, lors d'un fonctionnement initial, par exemple lors de la phase initiale d'apprentissage à la mise en communication de deux modem, il faut rattraper rapidement une erreur qui peut être importante. Par contre, une fois la correction initiale effectuée, par exemple tandis qu'un modem est en cours de communication, la phase n'est plus susceptible de varier dans des proportions importantes. On souhaite donc pendant la phase initiale utiliser un coefficient $K_L$ relativement élevé pour assurer un asservissement rapide puis, une fois que la communication est établie, diminuer le coefficient $K_L$ (et plus généralement les coefficients de filtrage K) pour permettre d'effectuer des petites corrections et ne pas tenir compte de fluctuations importantes instantanées correspondant normalement à des parasites accidentels.

On a donc déjà prévu dans l'art antérieur (voir, par exemple, DE-A-0356548) des boucles à verrouillage de phase numériques dans lesquelles les coefficients de filtrage sont modifiés entre une valeur haute initiale et une valeur plus faible de fonctionnement normal.

Toutefois, cette commutation relativement brutale de ce ou ces coefficients de filtrage K qui correspondent en quelque sorte à la constante de temps d'un filtre analogique peut dans certains cas, et notamment dans l'application aux modem dans lesquels d'autres algorithmes adaptatifs fonctionnent en parallèle de façon convergente, provoquer un décrochage de la boucle.

Pour pallier cet inconvénient, la présente invention prévoit un filtre numérique de boucle à verrouillage de phase numérique dans lequel les coefficients de filtrage sont régulièrement décrémentés à chaque pas d'horloge entre une valeur initiale et une valeur finale.

La présente invention prévoit en particulier que ces coefficients de filtrage sont décrémentés linéairement à chaque pas d'horloge même si cette décrémentation linéaire ne correspond pas à une variation linéaire de la largeur de bande du filtre.

L'invention s'applique, en particulier, à un filtre numérique de type proportionnel-intégral.

Selon un mode de réalisation de la présente invention, les moyens de décrémentation linéaire d'un coefficient comprennent un registre contenant la valeur courante du coefficient, des moyens pour charger initialement ce registre avec une valeur initiale, des moyens pour soustraire à chaque temps d'horloge au contenu du filtre un incrément, des moyens pour comparer la valeur courante du filtre à une valeur finale, et des moyens pour interrompre le fonctionnement du système de décrémentation quand la valeur courante du coefficient a atteint la valeur minimale.

Ces objets, caractéristiques et avantages ainsi que d'autres de la présente invention seront exposés en détail dans la description suivante d'un mode de réalisation particulier faite à titre non limitatif en relation avec les figures jointes parmi lesquelles :

les figures 1 et 2, décrites précédemment, correspondent aux figures 14-2 (page 551) et 14-6 (page 554) de l'ouvrage susmentionné de Lee et Messerschmitt ;

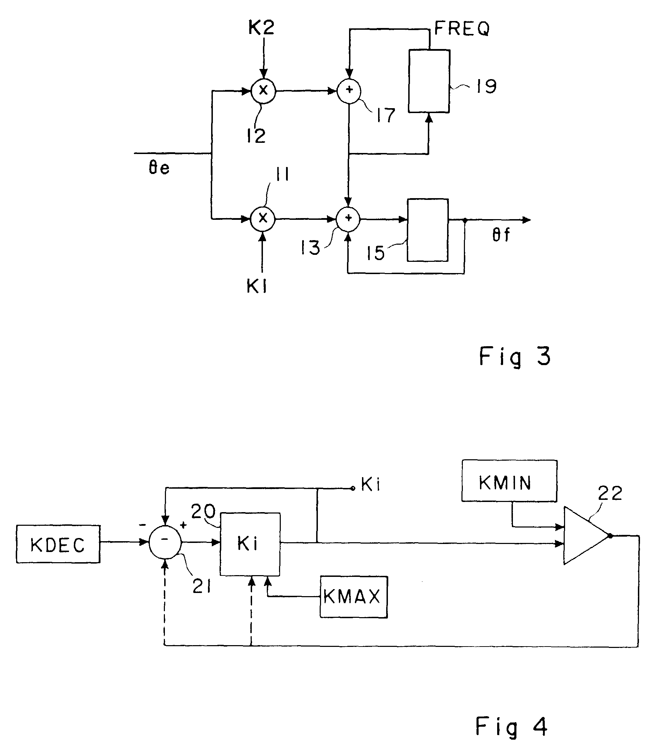

la figure 3 représente un exemple de filtre auquel s'applique la présente invention ; et
la figure 4 représente un exemple de circuit d'ajustement de coefficient de filtrage selon la présente invention.

La figure 3 représente un filtre numérique de type proportionnel-intégral qui constitue un exemple de filtre numérique de boucle à verrouillage de phase numérique auquel s'applique la présente invention. L'entrée de ce filtre reçoit un signal d'erreur, par exemple une erreur angulaire $\theta_e$ (appelée $\varepsilon_k$ en figure 1). Ce signal d'erreur est envoyé à deux circuits multiplieurs 11 et 12 effectuant respectivement des multiplications par des coefficients K1 et K2. La sortie du multiplieur 11 est envoyée à une première entrée d'un additionneur 13 dont la sortie est envoyée à un registre ou case mémoire 15. La sortie du multiplieur 12 est envoyée à une première entrée d'un additionneur 17 dont la sortie est rebouclée sur sa deuxième entrée par l'intermédiaire d'un registre 19 et est également envoyée à une deuxième entrée de l'additionneur 13. La sortie du registre 15 est appliquée à une troisième entrée de l'additionneur 13.

L'entrée $\theta_e$ est par exemple codée sur 16 bits, la sortie des multiplieurs 11 et 12 sur 32 bits et la sortie du registre ou case mémoire 15 sur 16 bits. Les registres 15 et 19 sont séquencés au rythme de l'horloge du système, l'horloge de bauds dans le cas d'un modem. A chaque temps d'horloge, les registres 15 et 19 fournissent la valeur qu'ils contiennent et remplacent cette valeur par la nouvelle valeur présentée sur leur entrée.

On appelle $FREQ_i$ l'erreur intégrée à un instant d'horloge $t_i$ dans le registre 19, cette erreur pouvant être considérée comme une erreur de fréquence. On appelle $\theta f_i$ l'erreur filtrée contenue dans le registre 15 à cet instant.

Ainsi à un instant $t_i$ on a

$$\theta f_i = \theta f_{i-1} + K1 \cdot \theta e_{i-1} + FREQ_{i-1}$$

$$FREQ_i = FREQ_{i-1} + K2 \cdot \theta e_{i-1}$$

Dans un tel filtre proportionnel-intégral, comme cela est connu, les valeurs de K1 et K2 définissent la bande passante du filtre.

La présente invention propose de modifier sur une durée déterminée, c'est-à-dire sur un nombre déterminé de périodes d'échantillonnage, la bande passante du filtre en modifiant chacun des coefficients K1, K2 à chaque temps d'horloge. Dans le cas du filtre particulier décrit, les coefficients doivent être diminués à chaque temps d'horloge si l'on veut diminuer la bande passante du filtre.

Un processus de réduction des valeurs des coefficients de filtrage K, utilisé pour chacun des coefficients, est illustré en figure 4. A un instant initial, une valeur initiale KMAX d'un coefficient K est introduite dans un registre ou case mémoire 20. La sortie de ce registre est envoyée à une entrée additionneuse d'un soustracteur 21 dont l'entrée de soustraction reçoit une valeur de décrémentation KDEC du coefficient K. On a donc à tout instant à la sortie du registre 20 une valeur

$$Ki = KMAX - i \cdot KDEC$$

qui est appliquée comme entrée de coefficient au multiplieur 11 ou 12 de la figure 3. La sortie Ki est également appliquée à un comparateur 22 qui compare oette valeur courante à une valeur minimale KMIN. Quand la valeur Ki atteint la valeur KMIN, la sortie du comparateur 22 inhibe le fonctionnement de la boucle 20, 21 et la valeur Ki reste fixée à la valeur KMIN.

Bien entendu, le circuit illustré en figure 4 ne constitue qu'un exemple de réalisation d'un circuit de décrémentation d'une valeur numérique et beaucoup d'autres moyens matériels et/ou logiciels pourront être utilisés pour assurer cette fonction.

Toutefois, selon un aspect de la présente invention, on préfère utiliser un processus analogue à celui illustré en figure 4 dans lequel la décrémentation des coefficients est une décrémentation linéaire. On notera qu'une décrémentation linéaire des coefficients K1 et K2 n'entraîne pas nécessairement une décrémentation linéaire de la bande passante du filtre. Par exemple, dans le cas d'un filtre proportionnel-intégral, alors que, pour obtenir une décrémentation linéaire de la bande passante du filtre, le coefficient K1 doit effectivement être décrémenté de façon linéaire, le coefficient K2 doit être décrémenté selon une fonction d'ordre plus élevé. Par exemple, si l'on réalise une décrémentation sur 500 temps d'horloge dans le cas d'un modem dont la fréquence d'échantillonnage est de 2400 Hz, et dont la fréquence porteuse est voisine de 1800 Hz, les valeurs initiales de K1 et K2 devront être choisies respectivement de $5,4.10^{-2}$ et de $1,5.10^{-3}$ pour avoir une largeur de bande de filtre de l'ordre de 10 Hz puis de $3,7.10^{-3}$ et $6,8.10^{-6}$ pour avoir une largeur de bande de l'ordre de 1 Hz. Avec une décrémentation linéaire, ceci donne au 250ème temps d'horloge pour K1 une valeur de $2,9.10^{-2}$

et pour K2 une valeur de l'ordre de 4,3.10$^{-4}$. Avec une décrémentation non-linéaire provoquant une réduction linéaire de la bande passante, on aurait au 250ème temps d'horloge la même valeur de K1 mais une valeur de K2 de sensiblement 7,5.10$^{-4}$. En pratique, il s'avère que l'approximation linéaire ne modifie pas sensiblement la convergence de la boucle.

Cette vérification réalisée par l'inventeur est importante puisque l'objet de la présente invention est de réaliser une boucle dont la convergence soit progressive et compatible avec la convergence d'autres algorithmes adaptatifs du modem, par exemple des boucles utilisées en relation avec les systèmes de suppression de gigue de phase.

La boucle à verrouillage comprenant un filtre numérique selon la présente invention a été décrite dans le cadre d'un double cas particulier : d'une part d'une boucle de récupération de porteuse dans un modem, d'autre part d'un filtre de type proportionnel-intégral. La présente invention s'appliquerait de la même manière à des applications à d'autres boucles (telles que des boucles d'annulation d'écho ou de récupération d'horloge) et à d'autres filtres. On notera que, dans des filtres distincts, par exemple d'ordre plus élevé, il est possible qu'il soit nécessaire pour arriver à une réduction de bande passante de faire croître et non pas décroître certains des coefficients de filtrage. L'invention s'appliquera à de tels filtres de façon correspondante, son aspect essentiel résidant dans la modification à chaque temps d'horloge des coefficients de filtrage entre une valeur initiale et une valeur finale.

## Revendications

1.  Boucle à verrouillage de phase comprenant un filtre numérique recevant des signaux d'erreur dans lequel les signaux d'erreur incidents subissent au moins une multiplication par un coefficient de filtrage (K) avant d'être traités numériquement à chaque temps d'horloge pour fournir un signal filtré, caractérisé en ce qu'il comprend des moyens de décrémentation linéaire de la valeur dudit au moins un coefficient de filtrage (K) à chaque temps d'horloge pendant une période initiale de fonctionnement du filtre.

2.  Boucle à verrouillage de phase selon la revendication 1, caractérisé en ce que le filtre est du type proportionnel-intégral.

3.  Boucle à verrouillage de phase selon l'une des revendications 1 ou 2, caractérisé en ce que les valeurs initiale et finale dudit au moins un coefficient (K) sont choisies pour que le filtre ait des bandes passantes initiale et finale prédéterminées.

4.  Modem comportant une boucle à verrouillage de phase selon l'une quelconque des revendications 1 à 3, caractérisé en ce que la fréquence à filtrer étant la fréquence porteuse et la fréquence d'échantillonnage étant la fréquence de bauds.

5.  Boucle à verrouillage de phase selon la revendication 1, caractérisé en ce que les moyens de décrémentation linéaire dudit au moins un coefficient (K) comprennent :

    un registre (20) contenant la valeur courante (K$_i$) du coefficient,
    des moyens pour charger initialement ce registre avec une valeur initiale (KMAX),
    des moyens (21) pour soustraire à chaque temps d'horloge au contenu du filtre un incrément (KDEC),
    des moyens (22) pour comparer la valeur courante du filtre à une valeur finale (KMIN), et
    des moyens pour interrompre le fonctionnement du système de décrémentation quand la valeur courante (K$_i$) du coefficient a atteint la valeur minimale (KMIN).

## Patentansprüche

1.  Phasenverriegelte bzw. phasensynchronisierte Regelschleife mit einem digitalen Filter, welchem Fehlersignale zugeführt werden und in welchem die ankommenden Fehlersignale wenigstens eine Multiplikation mit einem Filterkoeffizienten (K) erfahren, bevor sie bei jedem Taktimpuls zur Bildung eines gefilterten Signals digital verarbeitet werden, dadurch **gekennzeichnet**, daß die Schleife Mittel aufweist zur linearen Dekrementierung des Betrags des genannten wenigstens einen Filterkoeffizienten (K) bei jedem Taktimpuls während einer Anfangsperiode der Wirkungsweise des Filters.

2.  Phasenverriegelte bzw. -synchronisierte Regelschleife nach Anspruch 1, dadurch gekennzeichnet, daß das Filter vom Proportional-Integral-Typ ist.

3.  Phasenverriegelte bzw. -synchronisierte Regelschleife nach Anspruch 1 oder Anspruch 2, dadurch gekennzeichnet, daß der Anfangs- und der Endwert des genannten wenigstens einen Koeffizienten (K) so gewählt werden, daß das Filter vorgegebene Anfangs- und End- Durchlaßbänder aufweist.

4.  Modem mit einer phasenverriegelten bzw. -synchronisierten Regelschleife nach einem der Ansprüche 1 bis 3, dadurch gekennzeichnet, daß die zu filternde Frequenz die Trägerfrequenz und die Sample-Frequenz die Baud-Frequenz ist.

**5.** Phasenverriegelte bzw. -synchronisierte Regelschleife nach Anspruch 1, dadurch gekennzeichnet, daß die Mittel zur linearen Dekrementierung des genannten wenigstens einen Koeffizienten (K) umfassen:

ein Register (20), welches den laufenden Wert ($K_i$) des Koeffizienten enthält,

Mittel zum anfänglichen Laden des Registers mit einem Anfangswert (KMAX),

Mittel (21), um bei jedem Taktimpuls ein Inkrement (KDEC) vom Inhalt des Filters zu subtrahieren,

Mittel (22) zum Vergleichen des laufenden Werts des Filters mit einem Endwert (KMIN), sowie

Mittel zum Unterbrechen bzw. Abbrechen der Funktion des Dekrementierungssystems, sobald der laufende Wert ($K_i$) des Koeffizienten den Endwert (KMIN) erreicht.

## Claims

**1.** A phase-locked loop comprising a digital filter receiving error signals in which the incoming error signals are subject to at least one multiplication by a filtering coefficient (K) before being digitally processed at each clock pulse to provide a filtered signal, characterized in that it includes means for linearly decrementing the value of said at least one filtering coefficient (K) at each clock pulse during an initial operation period of the filter.

**2.** The phase-locked loop of claim 1, characterized in that said filter is of the proportionalintegral type.

**3.** The phase-locked loop of claim 1 or 2, characterized in that the initial and end values of said at least one coefficient (K) are selected so that the filter has predetermined initial and final bandwidths.

**4.** Modem incorporating the phase-locked loop of any of claims 1 to 3, characterized in that the frequency to be filtered is the carrier frequency, the sampling frequency being the baud frequency.

**5.** The phase-locked loop of claim 1, characterized in that said means for linearly decrementing said at least one coefficient (K) include:

a register (20) containing the current value (Ki) of the coefficient;
means for initially loading an initial value (KMAX) in said register;
means (21) for subtracting an incrementation value (KDEC), at each clock time, from the content of the filter;
means (22) for comparing the current value of the filter with an end value (KMIN); and
means for interrupting the operation of the decrementation system when the current value (Ki) of the coefficient has reached the minimum value (KMIN).

$$e^{j(\omega_c kT + \theta_k)} \sum_{m = -\infty}^{\infty} A_m p_{k-m}$$

Fig 1

Fig 2

Fig 3

Fig 4